# EUROPÄISCHE PATENTSCHRIFT

(11) **EP 0 780 698 B1**
(45) Veröffentlichungstag und Bekanntmachung des Hinweises auf die Patenterteilung: **31.07.2002**
(21) Anmeldenummer: 96114224.7
(22) Anmeldetag: 05.09.1996
(51) Int. Cl.: G01R 33/3815

(54) **NMR-Einrichtung mit Pulsrohrkühler**
NMR apparatus with pulse tube refrigerator
Appareil RMN avec un réfrigérateur à tube à gaz pulsé

(30) Priorität: 22.12.1995 DE 19548273
(43) Veröffentlichungstag der Anmeldung: 25.06.1997
(73) Patentinhaber: Bruker BioSpin AG, 8117 Fällanden (CH)
(72) Erfinder: Jeker, René, Dr., 8634 Hombrechtikon (CH); Di Nardo, Silvio, Dr., 8048 Zürich (CH); Mraz, Beat, 8634 Hombrechtikon (CH)
(74) Vertreter: KOHLER SCHMID + PARTNER

(56) Entgegenhaltungen:
- EP-A- 0 116 364
- DE-A- 4 020 593
- US-A- 3 237 421
- CRYOGENICS, Bd. 34, 1994, Seiten 155-158, XP000511555 Y. MATSUBARA, J. GAO: "MULTI-STAGED PULSE TUBE REFRIGERATOR FOR SUPERCONDUCTING MAGNET APPLICATIONS"
- ADVANCES IN CRYOGENIC ENGINEERING, Bd. 31, 1986, Seiten 517-532, XP002028579 R.C. LONGWORTH: "4 K Refrigerator and Interface for MRI Cryostats"

## Beschreibung

Die Erfindung betrifft ein hochauflösendes Kernspinresonanz (NMR) Spektrometer, mit einem supraleitenden Magnetspulensystem zur Erzeugung eines extrem homogenen Magnetfeldes enthaltenden Kryostaten, wobei das supraleitende Magnetspulensystem in einem ersten Tank mit kryogener Flüssigkeit angeordnet ist, welcher von Kühleinrichtungen wie Strahlungsschilden, Superisolationsfolie sowie einem zweiten Tank mit flüssigem oder festem Stickstoff, flüssiger oder fester Luft, flüssigem oder festem Sauerstoff, flüssigem Neon oder flüssigem Argon umgeben ist.

Ein NMR-Tomograph, der eine derartige NMR-Meßeinrichtung enthält, bei der die Anforderungen an die Homogenität des erzeugten Magnetfelds allerdings erheblich geringer als bei einem hochauflösenden NMR-Spektrometer sind, ist beispielsweise bekannt aus US 4,535,595.

Bei der bekannten Vorrichtung ist eine supraleitende NMR-Magnetspule in einem ersten Tank mit flüssigem Helium innerhalb eines Kryostaten angeordnet. Um diesen ersten Tank herum sind Strahlungsschilde sowie ein zweiter Tank mit flüssigem Stickstoff angeordnet. An der Außenhülle des Kryostaten befindet sich ein motorisch angetriebener Refrigerator, der über einen durch die Außenhülle führenden Kühlarm einen oder mehrere der Strahlungsschilde kühlt.

Da die supraleitende Magnetspule für NMR-Messungen, insbesondere bei der hochauflösenden NMR-Spektroskopie ein extrem homogenes Magnetfeld erzeugen muß, sind alle noch so geringen Störungen des Feldes unzulässig. Derartige Störungen werden aber insbesondere durch bewegte Teile im Zusammenhang mit dem Betrieb des Refrigerators hervorgerufen. Aus diesem Grund ist bei der Vorrichtung nach der US 4,535,595 eine Sensoreinrichtung zum Erfassen der vom motorischen Antrieb des Refrigerators ausgehenden magnetischen und/oder mechanischen Störsignale vorgesehen, die mindestens eine Korrekturspule zum Kompensieren des im Probenraum der NMR-Meßanordnung wirksamen, von dem Antrieb des Refrigerators verursachten Störfeldes steuert.

Damit kann die durch den Refrigerator hervorgerufene, vibrationsbedingte Magnetfeldstörung zwar im wesentlichen neutralisiert werden, jedoch ist dies bei der bekannten Apparatur mit einem sehr hohen technischen Aufwand, insbesondere nur durch eine Reihe von zusätzlichen Teilen wie Detektorspulen, Sensoreinrichtungen und einer entsprechenden zusätzlichen Steurelektronik möglich. Deshalb wird der Vorteil, der durch den Einsatz eines Refrigerators und die dadurch erzielbare längere Standzeit des Kryostaten und die verringerten Kälteverluste erreicht werden kann, wirtschaftlich und technisch zumindest teilweise wieder zunichte gemacht.

Aufgabe der vorliegenden Erfindung ist es daher, ein hochauflösendes NMR-Spektrometer mit den eingangs genannten Merkmalen derart zu modifizieren, daß einerseits die Kälteverluste des Kryostaten möglichst gering sind, so daß ein nahezu ununterbrochener Betrieb der NMR-Apparatur mit dem supraleitenden Magneten ermöglicht wird, wobei aber andererseits keine Feldstörungen durch die kryotechnischen Maßnahmen erzeugt werden, die insbesondere bei einem hochauflösenden NMR-Spektrometer extrem unerwünscht wären und mit sehr hohem technischen Aufwand wieder ausgeglichen werden müßten.

Erfindungsgemäß wird diese Aufgabe auf ebenso überraschend einfache wie wirkungsvolle Art und Weise dadurch gelöst, daß ein Pulsrohrkühler vorgesehen ist, dessen kaltes Ende kryotechnisch gut wärmeleitend mit dem zweiten Tank verbunden ist, und daß der zweite Tank mechanisch derart im Kryostaten befestigt ist, daß eine schwingungsgedämpfte und kryotechnisch schlecht wärmeleitende Ankopplung zwischen dem zweiten Tank und dem ersten Tank mit kryogener Flüssigkeit und dadurch zwischen dem zweiten Tank und dem supraleitenden Magnetspulensystem erreicht wird.

Durch die Verwendung eines Pulsrohrkühleres, wie er beispielsweise aus der Doktorarbeit von Jingtao Liang mit dem Titel "Development and Experimental Verification of a Theoretical Model for Pulse Tube Refrigeration", Institute of Engineering Thermophysics, Chinese Academy of Sciences, 1993, sowie darin zitierter Literatur an sich bekannt ist, anstelle eines mechanisch arbeitenden Refrigerators, werden von vornherein wesentlich weniger Feldstörungen erzeugt, da ein derartiger Pulsrohrkühler keine mechanisch bewegten, metallischen Teile aufweist, so daß auch im Betrieb keine Wirbelströme angeworfen werden, die die Feldhomogenität im Meßzentrum der NMR-Meßeinrichtung beeinträchtigen könnten. Auch die rein mechanisch übertragenen Vibrationen sind deutlich reduziert.

Trotz der an sich schon sehr vibrationsarmen Komponenten eines solchen Pulsrohrkühlers ist jedoch erfindungsgemäß zusätzlich vorgesehen, daß der im Inneren des Kryostaten befindliche zweite Tank, mit dem der Pulsrohrkühler an seinem kalten Ende kryotechnisch verbunden ist, schwingungsmäßig vom ersten Tank des Kryostaten, der das supraleitende Magnetspulensystem enthält, abgekoppelt ist. In der US 5,404,726 sind ausführlich Möglichkeiten einer mechanisch flexiblen thermischen Ankopplung beschrieben.

Auf diese Weise wird vollends sichergestellt, daß keine schädlichen Schwingungen auf das felderzeugende System übertragen werden und somit eine Beeinträchtigung der Feldhomogenität durch den Betrieb des Pulsrohrkühlers ausgeschlossen werden kann. Der technische Aufwand hierfür ist im Gegensatz zu den bekannten Lösungen, wie sie beispielsweise in der oben zitierten US 4,535,595 beschrieben sind, vernachlässigbar gering.

Die Erfindungsidee kann auch bei anderen als NMR-Apparaturen verwirklicht werden, bei denen einerseits eine effektive Kühlung in einem Kryostaten erforderlich ist und andererseits Vibrationen, aus welchen Gründen auch immer, unbedingt zu vermeiden sind.

Bei einer Ausführungsform der erfindungsgemäßen NMR-Meßeinrichtung ist der Pulsrohrkühler räumlich getrennt vom Kryostaten angeordnet. Dadurch wird eine Übertragung der bei Pulsrohrkühlern ohnehin äußerst geringen Vibration im Betrieb auf den Kryostaten vollständig vermieden.

Vorteilhaft ist eine Ausführungsform, bei der der Pulsrohrkühler mittels einer mechanisch flexiblen Verbindung kryotechnisch gut wärmeleitend und schwingungsgedämpft an den zweiten Tank angekoppelt ist. Dadurch wird zusätzlich zu der mechanischen Entkopplung des zweiten Tanks von dem ersten Tank auch schon die Fortpflanzung von Körperschall vom Pulsrohrkühler zum zweiten Tank von vornherein ausgeschlossen.

Dies ist insbesondere bei Ausführungsformen der erfindungsgemäßen NMR-Einrichtung vorteilhaft, bei der der Pulsrohrkühler unmittelbar außen am Kryostaten oder im Kryostaten angeordnet und mechanisch starr mit dem Kryostatengehäuse verbunden ist. Dies kann beispielsweise aus Platzgründen erforderlich sein, damit die gesamte Anlage so kompakt wie möglich gestaltet wird.

In den meisten Fällen wird die erfindungsgemäße NMR-Meßeinrichtung in ihrem das supraleitende Magnetspulensystem enthaltenden ersten Tank mit flüssigem Helium beschickt sein, welches die Supraleitfähigkeit des Spulenmaterials sicher ermöglicht.

Bei Weiterbildungen dieser Ausführungsformen kann als weitere Kühleinrichtung ein zweiter Tank mit flüssigem oder festem Stickstoff vorgesehen sein, der seinerseits den ersten Tank mit dem flüssigen Helium thermisch abschirmt und zu einer erhöhten Standzeitverlängerung des Kryostaten beiträgt.

Bei anderen Ausführungsformen der Erfindung kann der erste, das supraleitende Magnetspulensystem enthaltende Tank mit flüssigem, in Ausnahmefällen möglicherweise auch mit festem Stickstoff oder einem anderen kryogenen Medium beschickt sein, wobei das supraleitende Magnetspulensystem dann hochtemperatur-supraleitendes Material enthalten muß. Bei derartigen Kryosystemen würden das teuere flüssige Helium und die aufwendigen Kühleinrichtungen, die erforderlich sind, um das Helium flüssig zu halten, entfallen.

Bei weiteren Ausführungsformen der Erfindung kann das kalte Ende des Pulsrohrkühlers mit einem den ersten Tank umgebenden Strahlungsschild kryotechnisch gut wärmeleitend verbunden sein. Dadurch läßt sich entweder ein weiterer Tank mit kryogener Flüssigkeit einsparen oder zumindest die Standzeit der kryogenen Flüssigkeit im ersten Tank erheblich verlängern.

Eine weitere Verbesserung des Kühlverhaltens wird bei Weiterbildungen diese Ausführungsformen dadurch erreicht, daß der mit dem Pulsrohrkühler verbundene Strahlungsschild zusätzlich durch aus dem ersten Tank abdampfendes kryogenes Medium gekühlt wird. Auf diese Weise wird die in der Kühlflüssigkeit enthaltene Enthalpie noch besser ausgenutzt.

Besonders kompakt ist eine Ausführungsform der erfindungsgemäßen NMR-Meßeinrichtung, bei der an der Oberseite des Kryostaten ein Turm vorgesehen ist, wobei der Pulsrohrkühler in diesem Turm angeordnet ist.

Bei weiteren vorteilhaften Ausführungsformen sind an der Oberseite des Kryostaten Abdampftürme zum Abdampfen der kryogenen Flüssigkeiten aus dem ersten und aus dem zweiten Tank vorgesehen.

In den Rahmen der Erfindung fällt auch ein Verfahren zum Betrieb der erfindungsgemäßen NMR-Meßeinrichtung, bei der während des Betriebs des Kryostaten das kryogene Medium im zweiten Tank soweit abgekühlt wird, daß es in festem Aggregatszustand vorliegt. Die Abkühlung des kryogenen Mediums unter seinen Gefrierpunkt ist erfindungsgemäß beispielsweise dadurch zu erreichen, daß das kalte Ende des Pulsrohrkühlers kryotechnisch mit dem zweiten Tank verbunden ist. Übrigens muß das kryogene Medium im zweiten Tank nicht unbedingt vollständig ausgefroren werden, sondern es genügt auch ein teilweises Ausfrieren desselben, um schon erheblich verminderte Abdampfverluste zu erzielen.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung. Die in den Ansprüchen definierte Erfindung ist in der Zeichnung dargestellt und wird anhand von Ausführungsbeispielen näher erläutert. Es zeigen:
- Fig. 1: eine schematische Seitenansicht eines längs aufgeschnittenen Kryostaten einer erfindungsgemäßen NMR-Meßeinrichtung mit Pulsrohrkühler; und
- Fig. 2: eine schematische Detailansicht eines längs aufgeschnittenen Kryostaten, an welchen erfindungsgemäß ein Pulsrohrkühler angeschlossen ist.

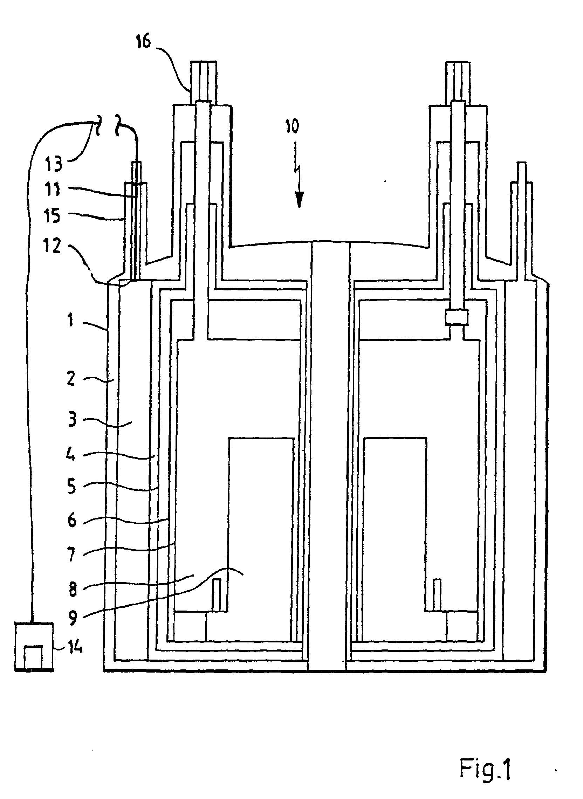

In Fig. 1 ist ein mit der Bezugsziffer 10 bezeichneter Kryostat dargestellt, der innerhalb eines Kryostatengehäuses 1 von außen nach innen gesehen ein Vakuumteil 2, einen Stickstofftank 3, in einem weiteren Vakuumteil 4 zwei Strahlungsschilde 5 und 6, um einen Heliumtank 8 eine Superisolationsfolie 7 sowie im Heliumtank 8 ein supraleitenden Magnetspulensystem 9, welches durch das es umgebende flüssige Helium gekühlt wird, aufweist. In einem Turm 15, der von dem Stickstofftank 3 nach außen führt, ist ein Pulsrohrkühler 11 angeordnet, dessen kaltes Ende 12 mit dem Stickstofftank 3 verbunden ist. Auf diese Weise kann der Pulsrohrkühler 11 kryotechnisch gut wärmeleitend mit dem flüssigen Stickstoff im zweiten Tank 3 verbunden sein, während er mechanisch starr am Kryostatengehäuse 1 befestigt ist.

Mittels einer flexiblen Schlauchverbindung 13 ist das "warme" Ende des Pulsrohrkühlers 11 mit einem Druckgenerator 14 verbunden, der den für den Betrieb des Pulsrohrkühlers 11 erforderlichen Druck erzeugt und über die Schlauchverbindung 13 an den Pulsrohrkühler 11 weitergibt.

Der mit flüssigem Helium gefüllte erste Tank 8, welcher das supraleitende Magnetspulensystem 9 enthält, ist in den Heliumabdampftürmen 16 aufgehängt. Ebenso ist der Stickstofftank 3 in Stickstoffabdampftürmen aufgehängt, so daß der Stickstofftank 3 schwingungsgedämpft an den Heliumtank 8 angekoppelt ist.

Anstelle von flüssigem Helium könnte im ersten Tank 8 auch flüssiger Stickstoff das Spulensystem 9 umgeben, sofern das letztere hochtemperatur-supraleitendes Material enthält. In diesem Falle würde der Stickstoff im ersten Tank 8 beispielsweise unter Einsatz eines Refrigerators ausgefroren werden, während er im zweiten Tank 3 in flüssigem Aggregatszustand belassen werden kann, wobei aber auch hier ein Ausfrieren des Stickstoffs mit Hilfe des Pulsrohrkühlers 11 denkbar ist.

Im zweiten Tank 3 können statt flüssigem Stickstoff auch andere flüssige oder feste kryogene Medien verwendet werden, beispielsweise Luft, Sauerstoff, Neon oder Argon, je nach den aktuellen experimentellen Erfordernissen.

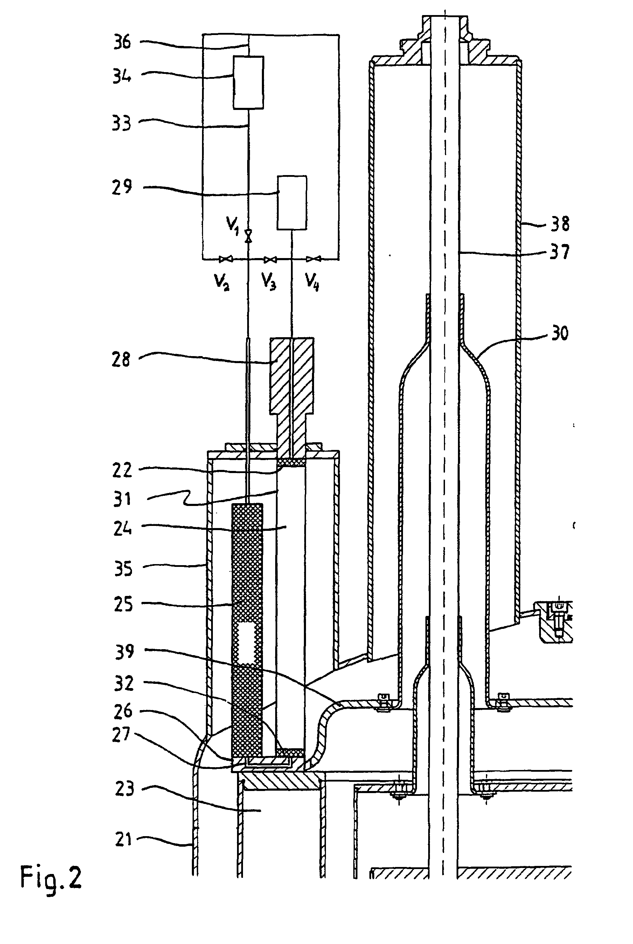

In Fig. 2 ist in einer schematischen Schnittansicht ein Detail des in Fig. 1 gezeigten Kryostaten dargestellt. In der linken oberen Hälfte von Fig. 2 ist ein Funktionsschema des Pulsrohrkühlers 31 gezeigt, der teilweise in einem Turm 35 innerhalb des Kryostatengehäuses 21 untergebracht ist. Das warme Ende 22 des Pulsrohrkühlers 35 ist dabei an einen auf Zimmertemperatur befindlichen Wärmetauscher 28 angekoppelt, während das kalte Ende 32 mittels eines Kontaktelementes 26 kryotechnisch gut wärmeleitend an einem Stickstofftank 23 innerhalb des Kryostaten angekoppelt ist. Zwischen dem warmen Ende 22 und dem kalten Ende 32 erstreckt sich das Pulsrohr 24. Die karierte Schraffur bei den beiden Enden 22 und 32 deutet jeweils eine Füllung mit Wärmetauschermaterial, beispielsweise Stahlwolle, Kupfernetze oder dergleichen an.

Über eine Verbindungsleitung 27 durch das Kontaktelement 26 ist das Pulsrohr 24 mit einem Regenerator 25 zum Wärmeaustausch des kryogenen Gases verbunden, mit dem der Pulsrohrkühler 31 betrieben wird.

Zur Erzeugung von Druckwellen in dem kryogenen Gas des Pulsrohrkühlers 31 ist ein Kompressor 34 vorgesehen, der eine Hochdruckleitung 33 mit etwa 30 bar und eine Niederdruckleitung 36 mit etwa 7 bar beschickt. Durch entsprechende Steuerung der Ventile V1, V2, V3 und V4 werden Druckstöße so erzeugt, daß sich im Pulsrohr 24 des Pulsrohrkühlers 31 Stoßwellen ausbilden. Zur Frequenzanpassung dient dabei ein Puffervolumen 29.

Zur Vermeidung von Vibrationsübertragungen auf das in dem Kryostaten untergebrachte NMR-Magnetsystem, welches sich in einem inneren, in der Figur 2 nicht dargestellten Heliumtank befindet, ist ein spiralwendelförmig geschlitztes Koppelelement 30 vorgesehen, mit welchem ein Strahlungsschild 39 mechanisch flexibel aber thermisch gut leitend an das Abdampfrohr 37 in einem Heliumabdampfturm 38 angekoppelt ist. Damit wird gleichzeitig die Enthalpie des abdampfenden Heliums optimal zur zusätzlichen Kühlung des Strahlungsschildes 39 ausgenutzt, ohne daß die Gefahr besteht, daß Schwingungen und damit Feldstörungen auf das Magnetsystem übertragen werden. Eine genaue Beschreibung von möglichen Ausführungsbeispielen des Koppelelementes 30 ist der US 5,404,726 zu entnehmen.

Um die Standzeiten des Kryostaten zu verlängern, kann der Stickstoff im Stickstofftank soweit abgekühlt werden, daß er im Betrieb in einem festen Aggregatszustand vorliegt.

## Patentansprüche

1. Kernspinresonanz (NMR)-Spektrometer mit einem ein supraleitendes Magnetspulensystem (9) zur Erzeugung eines extrem homogenen Magnetfeldes enthaltenden Kryostaten (10), wobei das supraleitende Magnetspulensystem (9) in einem ersten Tank (8) mit kryogener Flüssigkeit angeordnet ist, welcher von Kühleinrichtungen wie Strahlungsschilden (5, 6; 39) und Superisolationsfolie (7) sowie einem zweiten Tank (3; 23) mit flüssigem oder festem Stickstoff, flüssiger oder fester Luft, flüssigem oder festem Sauerstoff, flüssigem Neon oder flüssigem Argon umgeben ist, **gekennzeichnet dadurch, dass** ein Pulsrohrkühler (11; 31) vorgesehen ist, dessen kaltes Ende (12; 32) kryotechnisch gut wärmeleitend mit dem zweiten Tank (3; 23) verbunden ist, und dadurch dass der zweite Tank (3; 23) mechanisch derart im Kryostaten (10) befestigt ist, daß eine schwingungsgedämpfte und kryotechnisch schlecht wärmeleitende Ankopplung zwischen dem zweiten Tank (3; 23) und dem ersten Tank (8) mit kryogener Flüssigkeit, und dadurch zwischen dem zweiten Tank (3; 23) und dem supraleitenden Magnetspulensystem (9) erreicht wird.

2. NMR-Spektrometer nach Anspruch 1, **dadurch gekennzeichnet, daß** der Pulsrohrkühler räumlich getrennt vom Kryostaten angeordnet ist.

3. NMR-Spektrometer nach Anspruch 1 oder 2, **dadurch gekennzeichnet, daß** Pulsrohrkühler (11) mittels einer mechanisch flexiblen Verbindung (13), kryotechnisch gut wärmeleitend und schwingungsgedämpft an dem zweiten Tank (3; 23) angekoppelt ist.

4. NMR-Spektrometer nach Anspruch 3, **dadurch gekennzeichnet, daß** der Pulsrohrkühler (11; 31) unmittelbar außen am Kryostaten oder im Kryostaten (10) angeordnet und mechanisch starr mit dem Kryostatengehäuse (1; 21) verbunden ist.

5. NMR-Spektrometer nach einem der vorhergehenden Ansprüche, **dadurch gekennzeichnet, daß** der erste, das supraleitende Magnetspulensystem (9) enthaltende Tank (8) mit flüssigem Helium beschickt ist.

6. NMR-Spektrometer nach einem der Ansprüche 1 bis 4, **dadurch gekennzeichnet, daß** der erste, das supraleitende Magnetspulensystem enthaltende Tank mit flüssigem oder festem Stickstoff oder einem anderen kryogenen Medium beschickt ist, und daß das supraleitende Magnetspulensystem hochtemperatur-supraleitendes Material enthält.

7. NMR-Spektrometer nach einem der vorhergehenden Ansprüche, **dadurch gekennzeichnet, daß** das kalte Ende (32) des Pulsrohrkühlers (31) mit einem den ersten Tank umgebenden Strahlungsschild (39) kryotechnisch gut wärmeleitend verbunden ist.

8. NMR-Spektrometer nach Anspruch 7, **dadurch gekennzeichnet, daß** der mit dem Pulsrohrkühler (31) verbundene Strahlungsschild (39) zusätzlich durch aus dem ersten oder einem weiteren Tank abdampfendes kryogenes Medium gekühlt wird.

9. NMR-Spektrometer nach einem der vorhergehenden Ansprüche, **dadurch gekennzeichnet, daß** an der Oberseite des Kryostaten (10) ein Turm (15; 35) vorgesehen ist, in welchem ein Pulsrohrkühler (11; 31) angeordnet ist.

10. NMR-Spektrometer nach einem der vorhergehenden Ansprüche, **dadurch gekennzeichnet, daß** an der Oberseite des Kryostaten (10) Abdampftürme (15, 16; -38) zum Abdampfen der kryogenen Flüssigkeiten aus dem ersten und aus dem zweiten Tank (3 bzw. 8) vorgesehen sind.

11. Verfahren zum Betrieb eines NMR-Spektrometers nach einem der vorhergehenden Ansprüche, **dadurch gekennzeichnet, daß** das kryogene Medium im zweiten Tank (3; 23) während des Betriebs soweit abgekühlt wird, daß es zumindest teilweise in festem Aggregatszustand vorliegt.

## Claims

1. A nuclear magnetic resonance (NMR) spectrometer, having a cryostat (10) containing a superconducting magnetic coil system (9) for generating an extremely homogeneous magnetic field, wherein the superconducting magnet coil system (9) is disposed in a first tank (8) having cryogenic liquid and surrounded by cooling devices such as radiation shields (5, 6; 39) and superinsulation foil (7) and a second tank (3; 23) having liquid or solid nitrogen, liquid or solid air, liquid or solid oxygen, liquid neon or liquid argon, **characterized in that** a pulse tube cooler (11; 31) is provided whose cold end (12; 32) is cryotechnically connected in a good heat conducting fashion to the second tank (3; 23) and **in that** the second tank (3; 23) is mechanically attached in the cryostat (10) in such a fashion that a vibrationally damped and cryotechnically poor heat conducting coupling between the second tank (3; 23) and the first tank (8) having cryogenic liquid, and thereby between the second tank (3; 23) and the superconducting magnet coil system (9), is achieved.

2. NMR spectrometer according to claim 1, **characterized in that** the pulse tube cooler is disposed spatially separate from the cryostat.

3. NMR spectrometer according to claim 1 or 2, **characterized in that** the pulse tube cooler (11) is cryogenically coupled in a good heat conducting fashion and vibrationally damped to the second tank (3; 23) by means of a mechanically flexible connection (13).

4. NMR spectrometer according claim 3, **characterized in that** the pulse tube cooler (11; 31) is disposed directly on the outer side of the cryostat or in the cryostat (10) and is rigidly mechanically connected to the cryostat housing (1; 21)

5. NMR spectrometer according to any one of the preceding claims, **characterized in that** the first tank (8) containing the superconducting magnet coil system (9) is supplied with liquid helium.

6. NMR spectrometer according to any one of the claims 1 through 4, **characterized in that** the first tank NMR spectrometer according to any one of the claims 1 containing the superconducting magnet coil system is supplied with liquid or solid nitrogen or with another cryogenic medium and **in that** the superconducting magnet coil system comprises high temperature superconducting material.

7. NMR spectrometer according to any one of the preceding claims, **characterized in that** the cold end (32) of the pulse tube cooler (31) is cryogenically connected in a good heat conducting fashion to a radiation shield (39) surrounding the first tank.

8. NMR spectrometer according to claim 7, **characterized in that** the radiation shield (39) connected to the pulse tube cooler (31) is additionally cooled by a cryogenic medium evaporating from the first or from an additional tank.

9. NMR spectrometer according to any one of the preceding claims, **characterized in that** a tower (15; 35) is provided for on the upper side of the cryostat (10), a pulse tube cooler (11; 31) being disposed within the tower (15; 35).

10. NMR spectrometer according to any one of the preceding claims, **characterized in that** evaporation towers (15, 16; 38) are provided for on the upper side of the cryostat (10) for evaporation of the cryogenic fluid from the first and from the second tank (3 or 8).

11. Method for the operation of an NMR spectrometer according to any one of the preceding claims, **characterized in that** the cryogenic medium in the second tank (3; 23) is sufficiently cooled during operation so that it is at least partially present in solid state.

## Revendications

1. Spectromètre à résonance magnétique nucléaire (RMN) avec un cryostat (10) contenant un système à bobine excitatrice supraconductrice (9) pour la génération d'un champ magnétique extrêmement homogène, le système à bobine excitatrice supraconductrice (9) étant placé dans un premier réservoir (8) rempli de liquide cryogénique, lequel est entouré de dispositifs de refroidissement tels que écrans anti-rayonnement (5, 6 ; 39) et film de superisolation (7) ainsi que d'un deuxième réservoir (3 ; 23) rempli d'azote liquide ou solide, d'air liquide ou solide, d'oxygène liquide ou solide, de néon liquide ou d'argon liquide, **caractérisé par le fait qu'**il est prévu un refroidisseur à gaz pulsé (11 ; 31) dont l'extrémité froide (12 ; 32) est reliée d'une manière cryogéniquement bonne conductrice de la chaleur au deuxième réservoir (3 ; 23) et **par le fait que** le deuxième réservoir (3 ; 23) est fixé mécaniquement dans le cryostat (10) de telle manière que l'on obtient un couplage amorti en vibrations et cryogéniquement mauvais conducteur de la chaleur entre le deuxième réservoir (3 ; 23) et le premier réservoir (8) rempli de liquide cryogénique et par conséquent entre le deuxième réservoir (3 ; 23) et le système à bobine excitatrice supraconductrice (9).

2. Spectromètre à RMN selon la revendication 1, **caractérisé par le fait que** le refroidisseur à gaz pulsé est physiquement séparé du cryostat.

3. Spectromètre à RMN selon la revendication 1 ou 2, **caractérisé par le fait que** le refroidisseur à gaz pulsé (11) est couplé au deuxième réservoir (3 ; 23) au moyen d'une liaison mécanique flexible (13), d'une manière cryogéniquement bonne conductrice de la chaleur et amortie en vibrations.

4. Spectromètre à RMN selon la revendication 3, **caractérisé par le fait que** le refroidisseur à gaz pulsé (11 ; 31) est placé directement sur l'extérieur du cryostat ou dans le cryostat (10) et relié de manière mécaniquement rigide avec le carter de cryostat (1 ; 21).

5. Spectromètre à RMN selon l'une des revendications précédentes, **caractérisé par le fait que** le premier réservoir (8) contenant le système à bobine excitatrice supraconductrice (9) est rempli d'hélium liquide.

6. Spectromètre à RMN selon l'une des revendications 1 à 4, **caractérisé par le fait que** le premier réservoir (8) contenant le système à bobine excitatrice supraconductrice est rempli d'azote liquide ou solide ou d'un autre fluide cryogénique et que le système à bobine excitatrice supraconductrice contient un matériau supraconducteur à haute température.

7. Spectromètre à RMN selon l'une des revendications précédentes, **caractérisé par le fait que** l'extrémité froide (32) du refroidisseur à gaz pulsé (31) est reliée d'une manière cryogéniquement bonne conductrice de la chaleur à un écran anti-rayonnement (39) entourant le premier réservoir.

8. Spectromètre à RMN selon la revendication 7, **caractérisé par le fait que** l'écran anti-rayonnement (39) relié au refroidisseur à gaz pulsé (31) est refroidi en plus par un fluide cryogénique s'évaporant du premier ou d'un autre réservoir.

9. Spectromètre à RMN selon l'une des revendications précédentes, **caractérisé par le fait qu'**il est prévu sur la partie supérieure du cryostat (10) une tour (15 ; 35) dans laquelle est placé un refroidisseur à gaz pulsé (11 ; 31).

10. Spectromètre à RMN selon l'une des revendications précédentes, **caractérisé par le fait qu'**il est prévu sur la partie supérieure du cryostat (10) des tours d'évaporation (15, 16 ; 38) pour l'évaporation des liquides cryogéniques du premier et du deuxième réservoir (3 ou 8).

11. Procédé pour l'exploitation d'un spectromètre à RMN selon l'une des revendications précédentes, **caractérisé par le fait que** le fluide cryogénique du deuxième réservoir (3 ; 23) est refroidi pendant le fonctionnement au point d'être au moins partiellement à l'état solide.
